# FASCICULE DE BREVET EUROPEEN

(11) **EP 1 982 226 B1**
(45) Date de publication et mention de la délivrance du brevet: **01.07.2009**
(21) Numéro de dépôt: 07730842.7
(22) Date de dépôt: 23.01.2007
(51) Int. Cl.: G02B 27/22

(54) **SYSTEME OPTIQUE POUR VISUALISER UNE IMAGE A LA SURFACE D' UN PANNEAU SOLAIRE**
OPTISCHES SYSTEM ZUR ANZEIGE EINES BILDES AUF DER FLÄCHE EINES SONNENKOLLEKTORS
OPTICAL SYSTEM FOR DISPLAYING AN IMAGE ON THE SURFACE OF A SOLAR PANEL

(30) Priorité: 26.01.2006 FR 0600691
(43) Date de publication de la demande: 22.10.2008
(73) Titulaire: SAINT-GOBAIN GLASS FRANCE, 92400 Courbevoie (FR)
(72) Inventeur: GILBERT, Joël, F-13410 Lambesc (FR)
(74) Mandataire: Colombier, Christian
(86) Numéro de dépôt international: PCT/FR2007/000122
(87) Numéro de publication internationale: WO 2007/085721

(56) Documents cités:
- DE-A1- 19 519 417
- US-A- 5 303 525
- US-A- 5 680 734

## Description

La présente invention se rapporte à un système optique pour visualiser une image à la surface d'un panneau solaire.

On définit ici le terme de « panneau solaire » par tout type de surface, plane ou courbe, dont la fonction est de transformer l'énergie solaire en chaleur ou en électricité.

Pour obtenir la meilleure efficacité d'ensoleillement les panneaux solaires doivent être orientés en tenant compte des différentes positions du soleil sur le lieu géographique de l'installation. En général les panneaux solaires sont inclinés vers le Sud d'un angle égal à la latitude du lieu. Mais avec la baisse régulière des coûts de fabrication des panneaux solaires, notamment ceux de type photovoltaïque utilisant du silicium en couche mince, l'orientation des panneaux solaires deviendra moins nécessaire car le manque d'efficacité qui en découlera pourra être compensé, sans grande différence de prix, par une augmentation globale de la surface active. Ce qui facilitera par exemple la position verticale des panneaux solaires.

Les panneaux solaires sont généralement de couleur sombre, voire totalement noire, ce qui contraste fortement avec la couleur des supports sur lesquels ils sont fixés et ce qui va à l'encontre de leur intégration esthétique et architecturale.

La présente invention a pour objet de visualiser une image à la surface des panneaux solaires. Cette image ne fera que partiellement obstacle aux rayons solaires directs, ce qui permettra aux panneaux solaires de fonctionner avec un minimum de perte d'ensoleillement tout en bénéficiant des caractéristiques visuelles de l'image choisie. Afficher cette image ou cette couleur permettra donc de faciliter l'intégration esthétique des panneaux solaires. Cette image pourra aussi, par son contenu, devenir un moyen de communication de type informatif, signalétique ou publicitaire. On désignera ci-après le panneau solaire équipé du système optique objet de cette invention par le terme de « panneau solaire imageur ».

On définit ici le terme de « lumière ambiante » par la lumière totale reçue par le capteur solaire. La lumière ambiante est composée des rayons directs du soleil et de la lumière diffuse due à l'environnement.

La présente invention est constituée d'une surface lenticulaire, d'une image et d'un panneau solaire. La disposition relative de chacun de ces éléments permet sous certains angles d'observation de visualiser l'image en question sans voir la surface du panneau solaire, tout en permettant aux rayons solaires directs, qui possèdent des angles d'incidence différents des angles d'observation précédents, d'atteindrent la surface active du panneau solaire. La surface lenticulaire et l'image ne feront donc pas obstacle aux rayons solaires directs et feront seulement partiellement obstacle à la lumière diffuse environnante.

Le « panneau solaire imageur » objet de cette invention est constitué d'un film transparent sur lequel est imprimé une image dont des bandes rectilignes parallèles et équidistantes ont été effacées. On définit par le terme « bande image » les bandes restantes de l'image qui n'ont pas été effacées. Le film se positionne entre la surface active du panneau solaire et une surface lenticulaire. La surface lenticulaire est constituée d'une juxtaposition de lentilles rectilignes identiques, de type plan-convexe et dont la largeur vaut la somme d'une largeur de bande image et d'une largeur de bande transparente. Le film transparent est positionné du côté de la face plane de la surface lenticulaire, au plan focal des lentilles, de sorte que les bandes images et les bandes transparentes soient parallèles à l'axe longitudinal des lentilles. La largeur des bandes images et des bandes transparentes sont calculés pour que sous un certain intervalle d'angles de vision un observateur ne verra que les bandes images, donc l'image elle-même, alors que sous un autre intervalle d'angles de vision la lumière traversera les bandes transparentes, donc atteindra la surface active du capteur solaire. Les lentilles rectilignes concentrent en effet la lumière, donc la vision, sur des zones du plan focal dont la position dépend de l'angle d'incidence de la lumière à la surface de la lentille. La lumière frappe la face ondulée de la surface lenticulaire avec des angles d'incidence, mesurés par rapport à un axe perpendiculaire à la surface ondulée, qui prennent des valeurs comprises entre +45° et -45°. Aux intervalles d'angles d'incidence [A1, A2] et [A2, A3] correspondent des zones Z1 et Z2 du plan focal de la lentille. En positionnant convenablement les bandes images et les bandes transparentes de l'image respectivement en face des zones Z1 et Z2, un observateur dont les angles de visions seront compris entre A1 et A2 verra tes bandes images en zone Z1 donc l'image elle-même, alors que la lumière qui aura des angles d'incidence compris entre A2 et A3 se concentrera sur la zone Z2 et traversera les bandes transparentes pour atteindre la surface du capteur solaire. Le positionnement relatif de l'image par rapport à la surface lenticulaire se fera donc en fonction des différentes positions possible de l'observateur et des différentes positions possible du soleil dans le ciel; sachant que ces différentes positions angulaires détermineront les zones Z1 et Z2 où prendront place les bandes images et les bandes transparentes. Afin d'éviter les réflexions multiples de la lumière au passage de la surface lenticulaire au film, et du film à la surface du capteur solaire, les différents éléments pourront être collés avec une colle transparente de même indice de réfraction que les parties optiques en contact, ou bien les différentes surfaces pourront être traitées anti-reflet. Pour gagner en précision et supprimer une opération de collage l'impression de l'image pourra se faire directement sur la face plane de la surface lenticulaire. Selon un mode particulier de réalisation, le panneau solaire imageur reprendra les caractéristiques de la réalisation précédente mais la surface lenticulaire présentera cette fois sa face plane vers l'extérieur et une plaque transparente à faces parallèles s'intercalera entre la surface lenticulaire et l'image. Cette plaque transparente sera coupée perpendiculairement à sa surface, d'une manière rectiligne, et à intervalles réguliers, afin de faire apparaître des lames d'air planes de faible épaisseur qui seront parallèles à l'axe longitudinal des lentilles et positionnées en face de chaque jonction des lentilles. L'avantage de cette surface optique par rapport à la précédente est que les angles de vision et les angles d'incidence des rayons solaires pourront prendre des valeurs comprises entre -70° et +70°. En effet les rayons dont l'incidence sera supérieure à 45°, après leur passage au travers de la lentille, seront réfractés à l'intérieur de la plaque et réfléchis à la surface des lames d'air par le principe optique du saut d'indice de réfraction pour être dirigés à l'intérieur des zones Z1 ou Z2.

Selon un mode de réalisation particulier, et afin d'augmenter les angles de vision jusqu'à 90°, les lentilles rectilignes plan-convexe selon le mode de réalisation précédente seront remplacées par des lentilles rectilignes bi-convexes.

Selon un autre mode de réalisation l'image associée au capteur solaire imageur pourra être modifiable à distance, par exemple par l'utilisation d'un affichage à cristaux liquide. Si l'image se modifie rapidement on observera alors une image animée.

Selon une variante, non illustrée, l'image ou les images animées seront modifiées de sorte que les zones de même couleur que la surface du capteur solaire seront effacées pour devenir transparentes. Ainsi le rendu de l'image ne sera pas modifié car par transparence ces zones prendront la couleur du panneau solaire qui se trouve derrière. La lumière qui traversera ainsi l'image atteindra le capteur solaire et viendra donc s'ajouter à la lumière déjà reçue par ailleurs par le capteur.

Selon un autre mode de réalisation, les bandes images seront remplacées par des bandes de capteur solaire de faibles épaisseurs et le panneau solaire sera remplacé par une image fixe ou animée. Ces bandes de capteur solaire seront positionnées par rapport à la surface lenticulaire de manière à recevoir les rayons directs du soleil alors que les bandes transparentes permettront à un observateur positionné sous d'autres angles de vision, de voir l'image, ou les images animées, au travers du panneau solaire ainsi constitué.

Les dessins annexés illustrent l'invention :

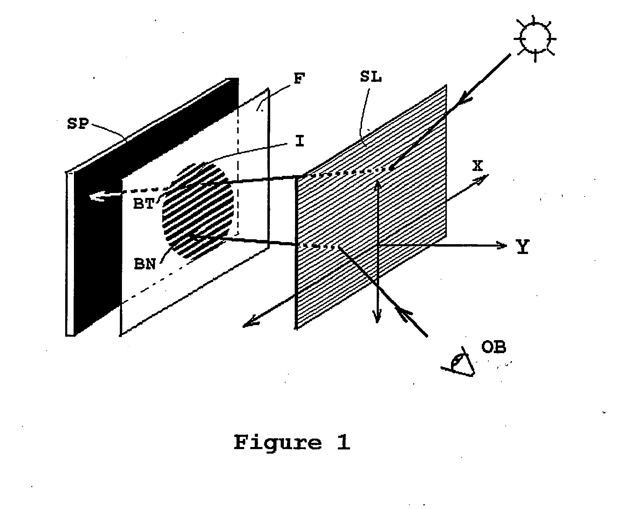

La figure 1 représente la disposition en vue éclatée des différents éléments composant le panneau solaire imageur.
La figure 2 représente une vue en coupe et le schéma de principe du panneau solaire imageur, avec d'une part la vision d'une image vue par un observateur et d'autre part le parcourt optique des rayons solaires qui, dans le même temps, atteignent la surface du capteur solaire.
La figure 3 représente un mode de réalisation particulier qui, afin d'augmenter les angles de vision, utilise une surface lenticulaire plan-convexe et la redirection des rayons selon le principe de la réflexion par saut d'indice de réfraction.

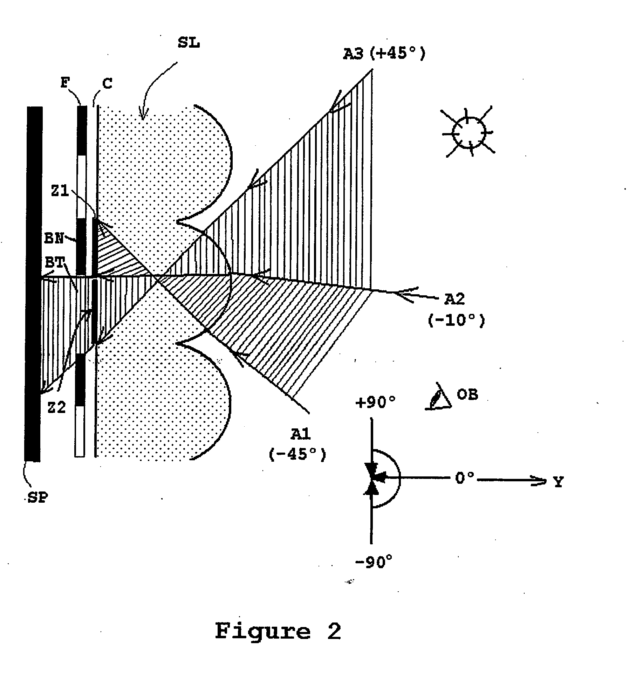

En référence à ces dessins, le système est composé d'un panneau solaire (SP), d'un film transparent (F) sur lequel est imprimée une image (I) et d'une surface lenticulaire (SL). L'image (I) est effacée en partie par des bandes transparentes (BT) rectilignes parallèles et équidistantes. L'image devient donc une image constituée de bandes images parallèles non transparentes (BN) et de bandes transparentes parallèles (BT). La surface lenticulaire est constituée de lentilles rectilignes identiques, de section plan-convexe, de largeur égale à la somme d'une largeur de bande image plus d'une largeur de bande transparente, et juxtaposées parallèlement les unes aux autres. Le film transparent (F) prend place entre le panneau solaire (SP) et la surface lenticulaire (SL), au plan focal des lentilles, avec la face ondulée de la surface lenticulaire tournée vers l'extérieur du système. Les bandes images (BN) et les bandes transparentes (BT) sont positionnées par rapport aux lentilles de sorte que ces bandes (BN et BT) soient parallèles à l'axe longitudinal (X) des lentilles, et de sorte que, vue sous certains angles compris dans l'intervalle d'angles [A1, A2], un observateur (OB) ne verra que les bandes images (BN). Par contre sous d'autres angles de vision compris dans l'intervalle d'angles [A2, A3] les rayons du soleil traverseront les bandes transparentes (BT) de l'image et atteindront la surface du capteur solaire (SP). Les bandes (BN) et (BT) se positionnent en face des zones Z1 et Z2. Les zones Z1 et Z2 représentent les zones du plan focal de la lentille rectiligne qui sont couvertes par les rayons dont les angles d'incidence sont compris respectivement dans les intervalles [A1,A2] et [A2,A3]. Dans le cas de lentilles dont le dioptre convexe est demi cylindrique (Figure 2), A1 et A3 prennent des valeurs limites de 45°. Ces angles sont mesurés par rapport à un axe (Y) qui est à la fois perpendiculaire à l'axe longitudinal des lentilles (X) et perpendiculaire à la surface lenticulaire (SL).

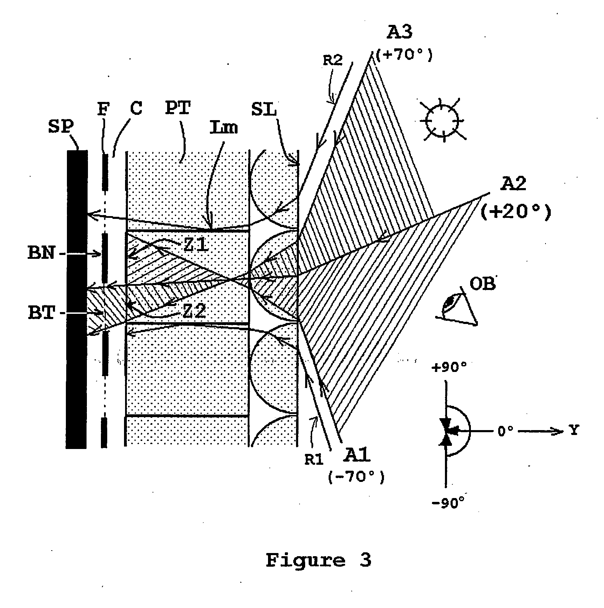

Dans le cas d'une réalisation avec une surface lenticulaire plan-convexe dont la face plane est tournée vers l'extérieur (Figure 3) les rayons incidents sont concentrés au passage du dioptre convexe de la lentille, puis subissent une réfraction au passage de la première face plane de la plaque transparente (PT). Une partie des rayons atteignent directement les zone Z1 et Z2 alors que d'autres (R1,R2), plus incidents, sont réfléchis à la surface de la lame d'air (Lm) avant d'atteindre les zones Z1 et Z2.

Afin de réduire les réflexions parasites, les différentes faces de la surface lenticulaire, de la plaque à faces parallèles et du capteur solaire, pourront subir un traitement anti-reflet ou bien le film pourra être collé avec une colle transparente (C) dont l'indice de réfraction sera identique à celui des parties optiques en contact.

A titre d'exemple, non limitatif, le panneau solaire sera de type photovoltaïque équipé d'un revêtement uniforme de silicium en couche mince. Le panneau solaire, de même que le film transparent et la surface lenticulaire seront de forme rectangulaire avec pour dimensions 60 centimètres de largeur et 100 centimètres de hauteur. Celui-ci est incliné vers le Nord de 22° par rapport à la verticale, et sa face active tournée vers le Sud. Sur le film transparent est imprimée en sérigraphie une image en couleur où alternent des bandes horizontales transparentes et non transparentes de même largeur égale à 0,5 mm. La surface lenticulaire est constituée de lentilles rectilignes de diamètre 1 mm et dont épaisseur fait 1,2 mm ce qui équivaut à la distance focale de chaque lentille. La surface lenticulaire est positionnée de telle sorte que l'axe longitudinal des lentilles soit à l'horizontal, donc parallèle aux bandes de l'image. Le film transparent est collé sur la face plane de la surface lenticulaire avec une colle transparente et positionné avec précision de sorte que chaque bande image se place dans la moitié haute du plan focal de chaque lentille. Chaque bande transparente se place alors dans la moitié basse du plan focal de chaque lentille. Pour un observateur placé à hauteur du panneau solaire imageur l'angle de vision vaut -22° ce qui permet de voir les bandes images. Le soleil, à son passage au méridien et à la latitude de 45°, peut prendre des hauteurs suivant les saisons variables entre 22° et 68° par rapport à l'horizon Sud, donc les rayons solaires prennent des angles d'incidences par rapport au panneau solaire compris entre 0° et 46°. Tous les rayons solaires traverseront donc les bandes transparentes et atteindront la surface du capteur solaire.

La présente invention est particulièrement adaptée à l'intégration esthétique et architecturale des panneaux solaires, ainsi qu'à la diffusion d'une information visuelle à la surface de ceux-ci.

## Revendications

1. Panneau solaire (SP) associé à un système optique permettant de visualiser une image à sa surface **caractérisé en ce qu'**il comporte un panneau solaire (SP), un film transparent image (F) dont a été effacé une série de bandes rectilignes parallèles de même largeur et équidistantes entre elles, et une surface lenticulaire constituée d'une juxtaposition de lentilles rectilignes identiques, dont la largeur vaut la somme d'une largeur de bande transparente plus une largeur de bande image, et dont la face plane est tournée vers l'image; l'axe longitudinal des lentilles étant parallèle aux bandes images et aux bandes transparentes, les dites bandes transparentes et bandes images étant positionnées entre la surface du panneau solaire et la surface lenticulaire, de telle sorte qu'un observateur ne verra que les bandes image ou que la surface du panneau solaire, cette alternative étant fonction de l'angle de vision sous lequel est observée la surface lenticulaire.

2. Panneau solaire selon la revendication 1, **caractérisé en ce que** les lentilles rectilignes ont une section plan convexe et/ou bi-convexe.

3. Panneau solaire associé à un système optique selon la revendication 2 **caractérisé en ce que** la surface de la lentille plan convexe et/ou bi-convexe présente sa face plane vers l'extérieur et qu'une plaque transparente à faces parallèles s'intercale entre la surface lenticulaire et le film, la dite plaque étant coupée perpendiculairement à sa surface, d'une manière rectiligne et à intervalles réguliers, laissant apparaître des lames d'air planes de faibles épaisseurs parallèles à l'axe longitudinal des lentilles et positionnées en face de chaque jonction des lentilles.

4. Panneau solaire associé à un système optique selon la revendication 1, 2 ou 3 **caractérisé en ce que** les différentes surfaces optiques possèdent un revêtement anti-reflet.

5. Panneau solaire associé à un système optique selon l'une quelconque des revendications précédentes **caractérisé en ce que** le film est collé aux différentes surfaces optiques avec une colle transparente dont l'indice de réfraction est identique à celui des parties optiques en contact.

6. Panneau solaire associé à un système optique selon l'une quelconque des revendications précédentes **caractérisé en ce que** les zones de l'image qui sont de même couleur que la surface du panneau solaire sont effacées pour devenir transparentes.

7. Panneau solaire associé à un système optique selon l'une quelconque des revendications précédentes **caractérisé en ce que** les bandes images sont remplacées par des bandes de capteur solaire, et le panneau solaire est remplacé par une image.

8. Panneau solaire associé à un système optique selon l'une quelconque des revendications précédentes **caractérisé en ce que** l'image fixe est remplacée par une image animée.

9. Panneau solaire selon l'une quelconque des revendications précédentes, **caractérisé en ce que** les bandes images et les bandes transparentes sont positionnées de façon que la lumière se concentre et traverse les bandes transparentes pour atteindre la surface du capteur solaire

10. Panneau solaire selon l'une quelconque des revendications précédentes, **caractérisé en ce que** l'image associée au capteur solaire imageur est un affichage à cristaux liquides.

## Claims

1. Solar panel (SP) associated with an optical system for displaying an image on its surface, **characterized in that** it comprises a solar panel (SP), an image transparent film (F) from which a series of parallel linear bands of identical width and equidistantly spaced apart have been removed, is printed, and a lenticular surface consisting of a juxtaposition of identical linear lenses, the width of which is equal to the sum of the width of a transparent band plus the width of an image band, and the plane face of which is turned towards the image, the longitudinal axis of the lenses being parallel to the image bands and to the transparent bands, said transparent bands and said image bands being positioned between the surface of the solar panel and the lenticular surface, in the focal plane of the lenses, in such a way that an observer will see only the image bands or only the surface of the solar panel, this alternative depending on the viewing angle at which the lenticular surface is observed.

2. Solar panel according to Claim 1, **characterized in that** the linear lenses have a plano-convex and/or bi-convex cross section.

3. Solar panel associated with an optical system according to Claim 2, **characterized in that** the surface of the plano-convex and/or bi-convex lens has its plane face towards the outside and **in that** a parallel-faced transparent plate is inserted between the lenticular surface and the film, said plate being cut perpendicular to its surface, in a linear manner, and at regular intervals, providing thin plane air slats parallel to the longitudinal axis of the lenses and positioned facing each junction of the lenses.

4. Solar panel associated with an optical system according to Claim 1, 2 or 3, **characterized in that** the various optical surfaces have an antireflection coating.

5. Solar panel associated with an optical system according to any one of the preceding claims, **characterized in that** the films bonded to the various optical surfaces using a transparent adhesive, the refractive index of which is identical to that of the optical parts in contact.

6. Solar panel associated with an optical system according to any one of the preceding claims, **characterized in that** the zones of the image that are of the same colour as the surface of the solar panel are removed, becoming transparent.

7. Solar panel associated with an optical system according to any one of the preceding claims, **characterized in that** the image bands are replaced with solar sensor bands and the solar panel is replaced with an image.

8. Solar panel associated with an optical system according to any one of the preceding claims, **characterized in that** the fixed image is replaced with an animated image.

9. Solar panel according to any one of the preceding claims, **characterized in that** the image bands and the transparent bands are positioned in such a way that the light is concentrated and passes through the transparent bands in order to reach the surface of the solar sensor.

10. Solar panel according to any one of the preceding claims, **characterized in that** the image associated with the imager solar sensor is a liquid-crystal display.

## Patentansprüche

1. Solarpanel (SP), das einem optischen System zugeordnet ist, welches das Anzeigen eines Bildes auf dessen Oberfläche ermöglicht, **dadurch gekennzeichnet, daß** es folgendes umfaßt, nämlich ein Solarpanel (SP), eine transparente Bild-Folie (F), aus der eine Reihe geradliniger, paralleler Streifen gleicher Breite, die untereinander gleich beabstandet sind, entfernt wurde, sowie eine Linsenfläche bestehend aus einer Nebeneinanderanordnung von identischen geradlinigen Linsen, deren Breite der Summe aus einer Breite eines transparenten Streifens und einer Breite eines Bildstreifens entspricht und deren ebene Fläche dem Bild zugewandt ist, wobei die Längsachse der Linsen zu den Bildstreifen und zu den transparenten Streifen parallel verläuft, wobei die transparenten Streifen und die Bildstreifen zwischen der Fläche des Solarpanels und der Linsenfläche angeordnet sind, so daß ein Beobachter lediglich die Bildstreifen oder lediglich die Fläche des Solarpanels sieht, wobei diese Alternative von dem Blickwinkel abhängig ist, unter dem die Linsenfläche betrachtet wird.

2. Solarpanel nach Anspruch 1, **dadurch gekennzeichnet, dass** die geradlinigen Linsen einen plankonvexen und/oder bikonvexen Querschnitt aufweisen.

3. Einem optischen System zugeordnetes Solarpanel nach Anspruch 2, **dadurch gekennzeichnet, dass** die ebene Seite der Oberfläche der plankonvexen und/oder bikonvexen Linse nach außen gewandt ist und dass eine transparente Platte mit parallelen Seiten zwischen der Linsenfläche und der Folie eingefügt ist, wobei die Platte senkrecht zu ihrer Oberfläche, geradlinig sowie in gleichmäßigen Abständen geschnitten ist, wodurch ebene Luftstreifen geringer Dicken entstehen, die zur Längsachse der Linsen parallel verlaufen und sich gegenüber einer jeden Verbindungsstelle der Linsen befinden.

4. Einem optischen System zugeordnetes Solarpanel nach Anspruch 1, 2 oder 3, **dadurch gekennzeichnet, dass** die verschiedenen optischen Flächen eine Antireflex-Beschichtung aufweisen.

5. Einem optischen System zugeordnetes Solarpanel nach einem der vorhergehenden Ansprüche, **dadurch gekennzeichnet, dass** die Folie mittels eines transparenten Klebers auf die verschiedenen optischen Flächen geklebt ist, dessen Brechungsindex mit demjenigen der in Kontakt befindlichen optischen Teile identisch ist.

6. Einem optischen System zugeordnetes Solarpanel nach einem der vorhergehenden Ansprüche, **dadurch gekennzeichnet, dass** die Bereiche des Bildes, welche die gleiche Farbe wie die Oberfläche des Solarpanels aufweisen, entfernt werden, um transparent zu werden.

7. Einem optischen System zugeordnetes Solarpanel nach einem der vorhergehenden Ansprüche, **dadurch gekennzeichnet, dass** die Bildstreifen durch Sonnenkollektorstreifen ersetzt sind und das Solarpanel durch ein Bild ersetzt ist.

8. Einem optischen System zugeordnetes Solarpanel nach einem der vorhergehenden Ansprüche, **dadurch gekennzeichnet, dass** das feste Bild durch ein bewegtes Bild ersetzt ist.

9. Solarpanel nach einem der vorhergehenden Ansprüche, **dadurch gekennzeichnet, dass** die Bildstreifen und die transparenten Streifen derart angeordnet sind, dass das Licht konzentriert wird und die transparenten Streifen durchquert, um die Oberfläche des Sonnenkollektors zu erreichen.

10. Solarpanel nach einem der vorhergehenden Ansprüche, **dadurch gekennzeichnet, dass** das dem bildgebenden Sonnenkollektor zugeordnete Bild eine Flüssigkristallanzeige ist.
